# EUROPEAN PATENT SPECIFICATION

(11) **EP 4 456 695 B1**
(45) Date of publication and mention of the grant of the patent: **17.06.2026**
(21) Application number: 23777965.7
(22) Date of filing: 22.03.2023
(51) Int. Cl.: H10K 30/80, H10K 30/50, H10K 30/30, H10K 85/10

(54) **METHOD FOR IMPROVING INTERFACIAL ADHESION OF ORGANIC SOLAR CELL, AND ORGANIC SOLAR CELL**
VERFAHREN ZUR VERBESSERUNG DER GRENZFLÄCHENADHÄSION EINER ORGANISCHEN SOLARZELLE UND ORGANISCHE SOLARZELLE
PROCÉDÉ D'AMÉLIORATION DE L'ADHÉRENCE INTERFACIALE D'UNE CELLULE SOLAIRE ORGANIQUE, ET CELLULE SOLAIRE ORGANIQUE

(30) Priority: 30.03.2022 CN 202210328224
(43) Date of publication of application: 30.10.2024
(73) Proprietor: Suzhou Institute of Nano-Tech and Nano-Bionics (SINANO), Chinese Academy of Sciences, Suzhou, Jiangsu 215123 (CN)
(72) Inventor: LUO, Qun, Suzhou, Jiangsu 215123 (CN); MA, Changqi, Suzhou, Jiangsu 215123 (CN); XU, Zihan, Suzhou, Jiangsu 215123 (CN); HAN, Yunfei, Suzhou, Jiangsu 215123 (CN)
(74) Representative: Bayramoglu et al.
(86) International application number: PCT/CN2023/083137
(87) International publication number: WO 2023/185595

(56) References cited:
- CN-A- 110 581 227
- CN-A- 113 644 203
- CN-A- 113 644 203
- CN-A- 114 695 676
- JP-A- 2018 085 497
- JIANG YOUYU ET AL: "Recent Advances of Synthesis, Properties, Film Fabrication Methods, Modifications of Poly(3,4-ethylenedioxythiophene), and Applications in Solution-Processed Photovoltaics", vol. 30, no. 51, 16 September 2020 (2020-09-16), DE, XP093237125, ISSN: 1616-301X, Retrieved from the Internet <URL:https://onlinelibrary.wiley.com/doi/full-xml/10.1002/adfm.202006213> [retrieved on 20250214], DOI: 10.1002/adfm.202006213
- ZHONGXIANG PENG ET AL: "Thermoplastic Elastomer Tunes Phase Structure and Promotes Stretchability of High-Efficiency Organic Solar Cells", ADVANCED MATERIALS, VCH PUBLISHERS, DE, vol. 33, no. 49, 11 October 2021 (2021-10-11), pages n/a, XP072497977, ISSN: 0935-9648, DOI: 10.1002/ADMA.202106732

## Description

### TECHNICAL FIELD

The present application relates to a preparation method of an organic solar cell, particularly to a method for improving the interfacial adhesion of an organic solar cell, as well as a corresponding organic solar cell and a preparation method thereof, belonging to the technical field of organic solar cell devices.

### BACKGROUND

Organic solar cells have received more and more attentions due to many advantages such as full solution preparation, light weight and wide material sources. Flexible organic solar cells can be applied to irregular surfaces such as human self-powered sensors, various roofs and tent surfaces, and therefore the flexible organic solar cells are required to have good mechanical stability.

Among them, the main structure of an inverted organic solar cell is a substrate/metal electrode/electron transport layer/active layer/molybdenum oxide/metal electrode. Since the organic solar cell is prepared layer by layer and multiple-layer materials are different materials which have different characters and include organic matters, metals, metal oxides and the like. When the organic solar cell is bent, stretched and crimped, the contact between various layers, especially a poor interface compatibility between the active layer and the zinc oxide and molybdenum oxide easily causes interface detachment, even cracks, thereby decaying cell photoelectric conversion efficiency, even leading to cell damage. Consequently, there is a need to consider not only the stability of the above layers themselves but also adhesion between various layers when the mechanical stability of the organic solar cell is improved.

At present, methods for improving the mechanical stability of flexible organic solar cells mainly focus on modification, decoration or replacement of each layer of the organic solar cell. The first method is to modify a flexible transparent conductive electrode in the organic solar cell; the second method is to perform doping or surface modification on an inorganic electron transport layer; the third method is to replace an inorganic hole transport layer with a copolymer polyolefin elastomer (POE) of ethylene and butene. These methods can improve the mechanical stability of the flexible organic solar cell, but the three methods make preparation of the organic solar cell more complex and costly. Although an organic material has better mechanical property than an inorganic film, a photoelectric organic film still has poor mechanical property because it typically contains crystalline and amorphous phases. To this end, the researchers conduct doping on the active layer to improve the mechanical stability of the active layer itself to improve the mechanical stability of the entire cell. However, a doping window is relatively small, so it is difficultly applied to industrialized preparation.

CN 113644203 A disclosed an organic solar cell based on a thermoplastic elastomer, and a method for preparing an organic solar cell based on a thermoplastic elastomer. In the organic solar cell, a thermoplastic elastomer is introduced as a third component into an active layer composed of a donor receptor, and the thermoplastic elastomer accounts for 2-90% of the total mass of the active layer material; the total mass is donor + acceptor + thermoplastic elastomer. In the method, the thermoplastic elastomer is used as the third component to be blended with electron donor and electron acceptor materials to prepare an active layer, and then prepare based on the active layer into organic solar cells.

The paper "Recent Advances of Synthesis, Properties, Film Fabrication Methods, Modifications of Poly(3,4-ethylenedioxythiophene), and Applications in Solution-Processed Photovoltaics" (URL:https://onlinelibrary.wiley.com/doi/full-xml/10.1002/adfm.202006213) disclosed that Poly(3,4-ethylenedioxythiophene) (PEDOT) is a very unique polymer. It can be very conductive, highly transparent, and environmentally stable. It is highly switchable between its oxidation state and neutral state. It forms a micellar complex with polystyrene sulfonate in aqueous conditions, and then can be solution-processible and printable. Based on these advantages, PEDOT has been widely used as conductors and transparent electrodes in electronics and optoelectronics. The device performance is highly correlated with the structure and properties of PEDOT. In this review, advances in the synthesis, optoelectronic and chemical properties are comprehensively described and analyzed, as well as the strategies for tuning these properties to fulfill the requirement for device applications. Film processing techniques (printing and transfer printing) for the conducting polymer are also presented. Then, the applications of PEDOT as conductors for versatile organic and perovskite solar cells (single-junction, tandem, semitransparent, colorful, flexible and ultraflexible, fully printed solar cells) are summarized. Finally future study directions for PEDOT in terms of conductivity enhancement and application-oriented formulations are discussed.

The paper "Thermoplastic Elastomer Tunes Phase Structure and Promotes Stretchability of High-Efficiency Organic Solar Cells" (URL: https://doi.org/10.1002/adma.202106732) disclosed that Top-performance organic solar cells (OSCs) consisting of conjugated polymer donors and nonfullerene small molecule acceptors (NF-SMAs) deliver rapid increases in efficiencies. Nevertheless, many of the polymer donors exhibit high stiffness and small molecule acceptors are very brittle, which limit their applications in wearable devices. Here, a simple and effective strategy is reported to improve the stretchability and reduce the stiffness of high-efficiency polymer: NF-SMA blends and simultaneously maintain the high efficiency by incorporating a low-cost commercial thermoplastic elastomer, polystyrene-block-poly(ethylene-ran-butylene)-block-polystyrene (SEBS). The microstructure, mechanical properties, and photovoltaic performance of PM6:N3 with varied SEBS contents and the molecular weight dependence of SEBS on microstructure and mechanical properties are thoroughly characterized. This strategy for mechanical performance improvement exhibits excellent applicability in some other OSC blend systems, e.g., PBQx-TF:eC9-2CI and PBDB-T:ITIC. More crucially, the elastic modulus of such complex ternary blends can be nicely predicted by a mechanical model. Therefore, incorporating thermoplastic elastomers is a widely applicable and cost-effective strategy to improve mechanical properties of nonfullerene OSCs and beyond.

JP2018085497A discloses a perovskite-type photoelectric conversion element that includes: a photoelectrode substrate having opposing conductive layers at least one of which is transparent; a counter electrode substrate having the conductive layer; and a photoelectric conversion layer disposed between the photoelectrode substrate and the counter electrode substrate and having a halide organic-inorganic hybrid perovskite compound as a component. The perovskite-type photoelectric conversion element has at least one adhesion layer.

### SUMMARY

The main objective of the present application is to provide a method for improving the interfacial adhesion of an organic solar cell as defined in the appended claims.

Another objective of the present application is also to provide an organic solar cell with excellent anti-bending property and a preparation method thereof as defined in the appended claims.

Compared with the prior art, the present application has the beneficial effects:
According to the present invention, the thermoplastic elastomers are used as interface layers alone, the thermoplastic elastomers become glue between functional layers, such as between the active layer and the hole transport layer or the electrode transport layer. This method adopts cheap commercial thermoplastic elastomers, and is simple in process; when the organic solar cell is prepared by using the active layer involved in the present invention, the prepared organic solar cell has high photoelectric conversion efficiency, strong adhesion between the active layer and the hole transport layer or the electron transport layer, and good cell mechanical stability.

### BRIEF DESCRIPTION OF THE DRAWINGS

In order to more clearly illustrate the technical solutions in the embodiments of the present application or in the prior art, the accompanying drawings required for use in the embodiments or the prior art will be simply presented below, obviously, accompanying drawings described below are only some embodiments of the present application, and other accompanying drawings can also be obtained by persons of ordinary skill in the art according to these accompanying drawings without creative efforts.
Fig.1 (not according to the present invention) is a structural diagram of a device in which thermoplastic elastomers are enriched at an upper interface of an active layer in an organic solar cell according to a typical embodiment of the present application;
Fig.2 (not according to the present invention) is a structural diagram of a device in which thermoplastic elastomers are enriched at a lower interface of an active layer in an organic solar cell according to a typical embodiment of the present application;
Fig.3 (not according to the present invention) is a structural diagram of a device in which upper and lower interfaces of an active layer have an enrichment layer formed by enrichment of thermoplastic elastomers according to a typical embodiment of the present application;
Fig.4 (not according to the present invention) is a normalized UV-visible absorption spectrogram of active layer PM6:Y6:SEBS in comparative example 1 and examples 1-3 when a weight ratio of SEBS to PM6 is 0%-100% according to the present application;
Fig.5 (not according to the present invention) is an adhesion bar graph of active layer PM6:Y6:SEBS in comparative example 1 and examples 1-3 when a weight ratio of SEBS to PM6 is 0%-100% according to the present application;
Fig.6 (not according to the present invention) is a picture showing that addition of SEBS prevents the detachment of MoO₃ and an Al film in example 2 of the present application;
Fig.7 (not according to the present invention) is a normalized UV-visible absorption spectrogram of an SEBS upper interface layer based on active layer PM6:Y6 in example 13 of the present application;
Fig.8 (not according to the present invention) is a picture showing that addition of SEBS prevents the detachment of MoO₃ and an Al film in example 14 of the present application; and
Fig.9 (not according to the present invention) is a picture showing that the detachment of MoO₃ and Al does not occur when SEBS is used as an upper interface adhesion layer of PM6:Y6 active layer in example 14 of the present application.

### DETAILED DESCRIPTION OF THE EMBODIMENTS

In view of the defects of the prior art, the inventors of this case propose the technical solution of the present application through long-term research and lots of practices for the purpose of providing a device structure for an organic solar cell interface based on thermoplastic elastomers, and a preparation method of this structure.

Next, the technical solution of the present application will be clearly and completely described, obviously, the described embodiments are some embodiments of the present application, but not all the embodiments. Based on the embodiments of the present application, other embodiments obtained by persons of ordinary skill in the art without creative efforts are all included within the scope of protection of the present application.

One aspect of the embodiments of the present application provides a method for improving the interfacial adhesion of an organic solar cell comprising a conductive substrate, a hole transport layer, an active layer, an electron transport layer and a metal electrode. The method comprises: arranging an elastomer interface layer, which is formed by thermoplastic elastomers, between at least two adjacent functional layers.

In some embodiments, the thermoplastic elastomer includes a combination of any one or more than two of a styrenic thermoplastic elastomer, an olefin thermoplastic elastomer, a diene thermoplastic elastomer, a vinyl chloride thermoplastic elastomer, a polyurethane thermoplastic elastomer, ester thermoplastic elastomer, an amide thermoplastic elastomer, an organic fluorine thermoplastic elastomer, an organic silicon thermoplastic elastomer and an ethylene thermoplastic elastomer, but is not limited thereto.

In some embodiments, the method for improving the interfacial adhesion of the organic solar cell comprises:
arranging the elastomer interface layer between the active layer and the hole transport layer and/or the electronic transport layer.

In some embodiments, the method for improving the interfacial adhesion of the organic solar cell comprises: forming the thermoplastic elastomer between the metal electrode and the hole transport layer and/or the electron transport layer to form the elastomer interface layer.

In some more specific embodiments, an achievement method for direct preparation of the thermoplastic elastomers between the upper and lower interface layers (i.e., a hole transport layer and/or an electron transport layer) of the active layer as an elastomer interface layer comprises:
dissolving thermoplastic elastomers into a selected solvent, and then deposing the formed thermoplastic elastomer solution on the surface of the active layer, the electron transport layer to form the elastomer interface layer (also referred to as a thermoplastic elastomer layer).

In some embodiments, the thickness of the elastomer interface layer is 0.1-50 nm, preferably 2-10 nm.

In some embodiments, the preparation method of the elastomer interface layer includes any one of spin coating, scratch coating, slit coating, gravure printing and inkjet printing, but is not limited thereto.

Further, when the thermoplastic elastomer solution is deposited above the active layer, the selected solvent is a second solvent which includes a combination of any one or more than two of an alcohol solvent, cycloalkane and alkane, preferably cycloalkane, but is not limited thereto.

Further, when the thermoplastic elastomer solution is deposited under the active layer, the selected solvent is a third solvent which includes a combination of any one or more than two of an alcohol solvent, cycloalkane, alkane, chloroform, chlorobenzene, tetrahydrofuran, dichlorobenzene, toluene, xylene and trimethylbenzene, preferably methanol, but is not limited thereto.

Another aspect of the embodiments not according to the present invention also provides an organic solar cell, comprising a conductive substrate, a hole transport layer, an active layer, an electron transport layer and a metal electrode, wherein an elastomer interface layer, which is formed by thermoplastic elastomers, is arranged between at least two adjacent functional layers.

In some embodiments, the types of the thermoplastic elastomers are described as above, and are not described in detail herein.

In some embodiments, the thickness of the active layer is 20-1000 nm, preferably 100-150 nm.

In some embodiments, the thickness of the elastomer interface layer is 0.1-50 nm, preferably 2-10 nm.

In some embodiments, the elastomer interface layer, which the elastomer interface layer is formed by the thermoplastic elastomers, is arranged between the active layer and the hole transport layer and/or the electron transport layer.

In some more specific embodiments, not according to the present invention, when the organic solar cell is in an orthostatic structure, the organic solar cell comprises a conductive substrate, a hole transport layer, an elastomer interface layer formed by thermoplastic elastomers, an active layer, the elastomer interface layer formed by the thermoplastic elastomers, an electron transport layer and a metal electrode which are successively laminated (from bottom to top).

In other some more specific embodiments, when the organic solar cell is in an inverted structure, the organic solar cell comprises a conductive substrate, an electron transport layer, an elastomer interface layer formed by thermoplastic elastomers, an active layer, the elastomer interface layer formed by the thermoplastic elastomers, a hole transport layer and a metal electrode which are successively laminated (from bottom to top).

Where the elastomer interface layer formed by the thermoplastic elastomers can only contain one layer, or can simultaneously contain two layers.

In some embodiments, the elastomer interface layer is arranged between the electron transport layer and the electrode, or between the hole transport layer and the electrode.

In some more specific embodiments, not according to the present invention, when the organic solar cell is in an orthostatic structure, the organic solar cell comprises a conductive substrate, a hole transport layer, an active layer, an electron transport layer, an elastomer interface layer formed by thermoplastic elastomers and a metal electrode which are successively laminated.

In other some more specific embodiments, not according to the present invention, when the organic solar cell is in an inverted structure, the organic solar cell comprises a conductive substrate, an electron transport layer, an active layer, a hole transport layer, an elastomer interface layer formed by thermoplastic elastomers and a metal electrode which are successively laminated.

In some embodiments, the conductive substrate comprises a polyethylene terephthalate, polyethylene naphthalate or polyimide flexible film covered with any one of a metal nanowire, a metal oxide, a metal grid, graphene and a carbon nanotube on the surface.

Further, the conductive substrate is the polyethylene terephthalate (PET) flexible film covered with the metal nanowire on the surface.

Where the thickness of the conductive substrate is related to a specific electrode material and mostly limited by transmittance and square resistance, the square resistance of a high-performance conductive substrate is generally 10Ω/□ or even lower, at this moment, the higher transmittance is better.

In some embodiments, the material of the electron transport layer includes a combination of any one or more than two of a zinc oxide nanoparticle, sol-gel zinc oxide, PFN-Br and PDINO, but is not limited thereto.

Further, the electron transport layer is the zinc oxide nanoparticle.

Further, the thickness of the electron transport layer is 10-30 nm.

In some embodiments, the material of the hole transport layer comprises molybdenum oxide and/or PEDOT:PSS and the like, preferably molybdenum oxide.

Further, the thickness of the hole transport layer is 10-30 nm.

Further, the active layer is a donor and acceptor blending system having photovoltaic property.

Further, the material of the metal electrode includes aluminum, silver or gold undergoing vacuum evaporation, or a silver nanowire prepared by using spin coating, scraping coating, slit coating, inkjet printing or other methods, but not limited thereto.

Further, the thickness of the metal electrode is 50-1000 nm.

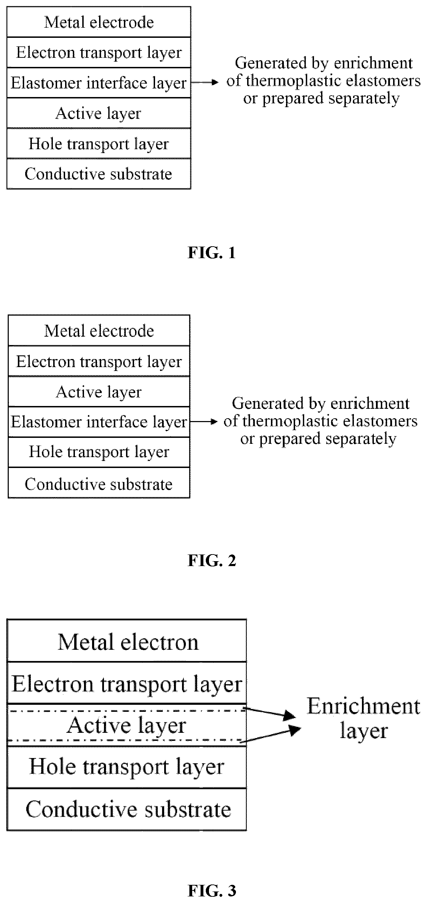

In some more specific embodiments, not according to the present invention, as shown in FIG. 1, when the thermoplastic elastomers are enriched at the upper interface of the active layer of the organic solar cell, the structure of the organic solar cell from bottom to top successively comprises: a conductive substrate, a hole transport layer, an active layer, an elastomer interface layer formed by the thermoplastic elastomers, an electron transport layer and a metal electrode.

In some more specific embodiments, not according to the present invention, as shown in FIG. 2, when the thermoplastic elastomers are enriched at the lower interface of the active layer of the organic solar cell, the structure of the organic solar cell from bottom to top successively comprises: a conductive substrate, a hole transport layer, an elastomer interface layer formed by the thermoplastic elastomers, an active layer, an electron transport layer and a metal electrode.

In the present application, a mechanism that the arrangement of the elastomer interface layer can improve the adhesion lies in that: a hydrogen bond is formed between H atoms contained in the elastomer interface layer formed by the thermoplastic elastomers and F, N and O atoms that may be contained in the active layer/F, N and O atoms that may be contained in the electron transport layer, increasing an action force (i.e., adhesion) between the elastomer interface layer and the active layer/electron transport layer or other functional layers.

Another aspect of the embodiments of the present application also provides a preparation method of an organic solar cell, comprising: arranging an elastomer interface layer, which is formed by thermoplastic elastomers, between at least two adjacent functional layers.

Another aspect of the embodiments, not according to the present invention, of the present application also provides a preparation method of an organic solar cell with an orthostatic structure, comprising:
providing a conductive substrate;
forming a hole transport layer on the conductive substrate;
forming an active layer on the hole transport layer;
allowing thermoplastic elastomers to form an elastomer interface layer between the hole transport layer and the active layer according to the previous method;
forming an electron transport layer on the elastomer interface layer; and
forming a metal electrode on the electron transport layer.

The embodiments of the present application also provide a preparation method of an organic solar cell with an inverted structure, comprising:
providing a conductive substrate;
forming an electron transport layer on the conductive substrate;
forming an active layer on the electron transport layer;
allowing thermoplastic elastomers to form an elastomer interface layer between the electron transport layer and the active layer according to the previous method;
forming a hole transport layer on the elastomer interface layer; and
forming a metal electrode on the hole transport layer.

Where the elastomer interface layer formed by the thermoplastic elastomers can only contain one layer, or can simultaneously contain two layers.

The embodiments of the present application also provide a preparation method of another organic solar cell, comprising: arranging an elastomer interface layer between the electron transport layer and the electrode, or between the hole transport layer and the electrode.

Specifically, as a preferred embodiment, not according to the present invention, the preparation method comprises:
providing a conductive substrate;
forming a hole transport layer on the conductive substrate;
forming an active layer on the hole transport layer;
forming an electron transport layer on the active layer;
allowing thermoplastic elastomers to form an elastomer interface layer on the electron transport layer; and
forming a metal electrode on the elastomer interface layer.

Specifically, as a preferred embodiment, not according to the present invention, the preparation method comprises:
providing a conductive substrate;
forming an electron transport layer on the conductive substrate;
forming an active layer on the electron transport layer;
forming a hole transport layer on the active layer;
allowing thermoplastic elastomers to form an elastomer interface layer on the hole transport layer; and
forming a metal electrode on the elastomer interface layer.

Further, the preparation method of the hole transport layer comprises: preparing the hole transport layer by using any one of vacuum evaporation, spin coating, scratch coating, slit coating, gravure printing, inkjet printing and other methods.

Further, the preparation method of the metal electrode comprises: preparing the metal electrode by using any one of vacuum evaporation, spin coating, scratch coating, slit coating, inkjet printing and other methods.

Further, the metal electrode is aluminum, silver and gold undergoing vacuum evaporation, or a silver nanowire prepared by using spin coating, scratch coating, slit coating, inkjet printing and other methods, with a thickness of 50-1000 nm.

Furthermore, the metal electrode is vacuum evaporated aluminum with a thickness of 150 nm.

Next, the specific embodiments of the present application will be described in detail in combination with examples. The following examples are used for illustrating the present application, but are not intended to limit the scope of the present application. On the contrary, providing these examples are intended to explain the principle and actual application of the present invention, so as to make other technicians in the art more understand various embodiments of the present application and various modifications suitable for specific predicted applications.

Unless specified otherwise, various raw materials, production equipment, test equipment and the like used in the following examples are all available in the markets. Test methods adopted are also test methods well-known in the art.

### Comparative example 1

An inverted organic solar cell structure in this example from bottom to top comprised a conductive substrate, an electron transport layer, an active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode is vacuum evaporated aluminum with a thickness of 150 nm. The performances of the organic solar cell were tested under standard test conditions (AM1.5, 100 mW/cm²). The open circuit voltage (*V_{oc}*) of the cell is measured as 0.82 V, the short circuit current density was measured as 24.97 mA/cm², the filling factor (FF) was measured as 69.51%, and the power conversion efficiency (PCE) was measured as 14.21%. By testing, the surface adhesion of the active layer in this comparative example was 9.38 nN. By testing, the power conversion efficiency (PCE) of the cell after 5000 times of outward bending cycles was maintained as 83% of an initial value.

### Example 1 (not included in the present invention)

An inverted organic solar cell structure in this example from bottom to top comprised a conductive substrate, an electron transport layer, a styrene ethylene butylene styrene (SEBS) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material was 1:1.2, and the concentration of a solution was 8 mg/ml based on PM6; the selected thermoplastic elastomer was SEBS, and its ratio was 10%; the hole transport layer was evaporated molybdenum oxide with a thickness of 10 nm; the metal electrode was vacuum evaporated aluminum with a thickness of 150 nm. In this ratio, the thermoplastic elastomer enrichment layer formed on the surface of the active layer was 0.5 nm in thickness; the performances of the organic solar cell were tested under standard test conditions (AM1.5, 100 mW/cm²), the open circuit voltage (*V_{oc}*) of the cell was measured as 0.83 V, the short circuit current density (*J_{sc}*) was measured as 24.66 mA/cm², the filling factor (FF) was measured as 69.24%, and the power conversion efficiency (PCE) was measured as 14.12%. The surface adhesion of the active layer in this example was 15.39 nN. The power conversion efficiency (PCE) of the cell after 5000 times of outward bending cycles was maintained as 84% of an initial value.

Relative to comparative example 1, the surface adhesion is improved by 164%, and the efficiency maintenance after bending cycle is improved by 1%.

### Example 2 (not included in the present invention)

An inverted organic solar cell structure in this example from bottom to top comprised a conductive substrate, an electron transport layer, an SEBS doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material was 1:1.2, and the concentration of a solution was 8 mg/ml based on PM6; the selected thermoplastic elastomer was SEBS, and its ratio was 50%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 3 nm in thickness; the performances of the organic solar cell were tested under standard test conditions (AM1.5, 100 mW/cm²), the open circuit voltage (*V_{oc}*) of the cell was measured as 0.81 V, the short circuit current density (*J_{sc}*) was measured as 24.19 mA/cm², the filling factor (FF) was measured as 69.40%, and the power conversion efficiency (PCE) was measured as 13.60%. The surface adhesion of the active layer in this example was 21.75 nN. The power conversion efficiency (PCE) of the cell after 5000 times of outward bending cycles was maintained as 85% of an initial value.

Relative to comparative example 1, the surface adhesion is improved by 232%, and the efficiency maintenance after bending cycle is improved by is improved by 2%.

### Example 3 (not included in the present invention)

An inverted organic solar cell structure in this example from bottom to top comprised a conductive substrate, an electron transport layer, an SEBS doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material was 1:1.2, and the concentration of a solution was 8 mg/ml based on PM6; the selected thermoplastic elastomer was SEBS, and its ratio was 100%; the hole transport layer was vacuum evaporated molybdenum oxide with a thickness of 10 nm; the metal electrode was vacuum evaporated aluminum with a thickness of 150 nm. In this ratio, the thermoplastic elastomer enrichment layer formed on the surface of the active layer was 10 nm in thickness; the performances of the organic solar cell were tested under standard test conditions (AM1.5, 100 mW/cm²), the open circuit voltage (*V_{oc}*) of the cell was measured as 0.81 V, the short circuit current density (*J_{sc}*) was measured as 22.60 mA/cm², the filling factor (FF) was measured as 67.23%, and the power conversion efficiency (PCE) was measured as 12.34%. The surface adhesion of the active layer in this example was 25.55 nN. The power conversion efficiency (PCE) of the cell after 5000 times of outward bending cycles was maintained as 87% of an initial value.

Relative to comparative example 1, the surface adhesion is improved by 274%, and the efficiency maintenance after bending cycle is improved by is improved by 4%.

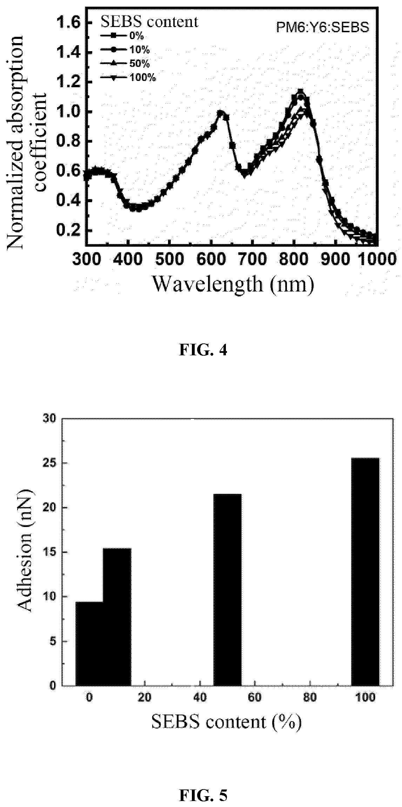

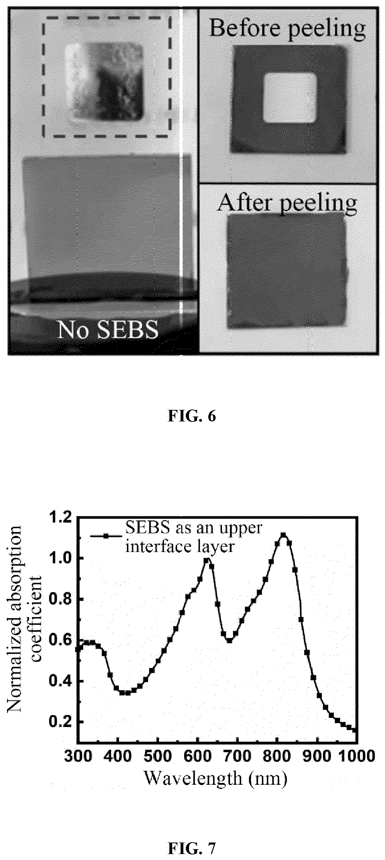

FIG. 4 is a normalized UV-visible absorption spectrogram of active layer PM6:Y6:SEBS in comparative example 1 and examples 1-3 when a weight ratio of SEBS to PM6 is 0%-100%; FIG. 5 is an adhesion bar graph of active layer PM6:Y6:SEBS in comparative example 1 and examples 1-3 when a weight ratio of SEBS to PM6 is 0%-100%. FIG. 6 shows that when SEBS is an adhesive layer, the adhesion of molybdenum oxide and Al on the active layer is improved, and the use of a 3M adhesive tape does not allow the film to fall off. By comparison, complete peeling occurs for a film without SEBS as the adhesive layer.

### Example 4 (not included in the present invention)

An inverted organic solar cell structure in this example from bottom to top comprised a conductive substrate, an electron transport layer, an SEBS doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material is Y6, a mass ratio of the donor material to the acceptor material was 1:1.2, and the concentration of a solution was 8 mg/ml based on PM6; the selected thermoplastic elastomer was SEBS, and its ratio was 200%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 20 nm in thickness; the performances of the organic solar cell were tested under standard test conditions (AM1.5, 100 mW/cm²), the open circuit voltage (*V_{oc}*) of the cell was measured as 0.81 V, the short circuit current density (*J_{sc}*) was measured as 22.11 mA/cm², the filling factor (FF) was measured as 66.11%, and the power conversion efficiency (PCE) was measured as 11.84%. The surface adhesion of the active layer in this example was 26.79 nN. The power conversion efficiency (PCE) of the cell after 5000 times of outward bending cycles was maintained as 88% of an initial value.

Relative to comparative example 1, the surface adhesion is improved by 286%, and the efficiency maintenance after bending cycle is improved by 5%.

### Example 5 (not included in the present invention)

An inverted organic solar cell structure in this example from bottom to top comprised a conductive substrate, an electron transport layer, a thermoplastic polyurethane (TPU) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material was 1:1.2, and the concentration of a solution was 8 mg/ml based on PM6; the selected thermoplastic elastomer was TPU, and its ratio was 50%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 10 nm in thickness; the performances of the organic solar cell were tested under standard test conditions (AM1.5, 100 mW/cm²), the open circuit voltage (*V_{oc}*) of the cell was measured as 0.81 V, the short circuit current density (*J_{sc}*) was measured as 24.28 mA/cm², the filling factor (FF) was measured as 69.94%, and the power conversion efficiency (PCE) was measured as 13.82%. The surface adhesion of the active layer in this example was 17.82 nN. The power conversion efficiency (PCE) of the cell after 5000 times of outward bending cycles was maintained as 86% of an initial value.

Relative to comparative example 1, the surface adhesion is improved by 190%, and the efficiency maintenance after bending cycle is improved by 3%.

### Example 6 (not included in the present invention)

An inverted organic solar cell structure in this example from bottom to top comprised a conductive substrate, an electron transport layer, a thermoplastic polyimide (TPI) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material is Y6, a mass ratio of the donor material to the acceptor material was 1:1.2, and the concentration of a solution was 8 mg/ml based on PM6; the selected thermoplastic elastomer was TPI, and its ratio was 50%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 7 nm in thickness; the performances of the organic solar cell were tested under standard test conditions (AM1.5, 100 mW/cm²), the open circuit voltage (*V_{oc}*) of the cell was measured as 0.81 V, the short circuit current density (*J_{sc}*) was measured as 24.99 mA/cm², the filling factor (FF) was measured as 69.40%, and the power conversion efficiency (PCE) was measured as 14.30%. The surface adhesion of the active layer in this example was 19.31 nN. The power conversion efficiency (PCE) of the cell after 5000 times of outward bending cycles was maintained as 84% of an initial value.

Relative to comparative example 1, the surface adhesion is improved by 206%, and the efficiency maintenance after bending cycle is improved by 1%.

### Example 7 (not included in the present invention)

An inverted organic solar cell structure in this example from bottom to top comprised a conductive substrate, an electron transport layer, a thermoplastic vulcanized rubber (TPV) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material was 1:1.2, and the concentration of a solution was 8 mg/ml based on PM6; the selected thermoplastic elastomer was TPV, and its ratio was 50%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 5 nm in thickness; the performances of the organic solar cell were tested under standard test conditions (AM1.5, 100 mW/cm²), the open circuit voltage (*V_{oc}*) of the cell was measured as 0.83 V, the short circuit current density (*J_{sc}*) was measured as 24.79 mA/cm², the filling factor (FF) was measured as 68.99%, and the power conversion efficiency (PCE) was measured as 14.20%. The surface adhesion of the active layer in this example was 20.09 nN. The power conversion efficiency (PCE) of the cell after 5000 times of outward bending cycles was maintained as 86% of an initial value.

Relative to comparative example 1, the surface adhesion is improved by 214%, and the efficiency maintenance after bending cycle is improved by 3%.

### Example 8 (not included in the present invention)

An inverted organic solar cell structure in this example from bottom to top comprised a conductive substrate, an electron transport layer, a thermoplastic polyvinyl chloride (TPVC) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material is Y6, a mass ratio of the donor material to the acceptor material was 1:1.2, and the concentration of a solution was 8 mg/ml based on PM6; the selected thermoplastic elastomer was TPVC, and its ratio was 50%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 2 nm in thickness; the performances of the organic solar cell were tested under standard test conditions (AM1.5, 100mW/cm²), the open circuit voltage (*V_{oc}*) of the cell was measured as 0.82 V, the short circuit current density (*J_{sc}*) was measured as 24.19 mA/cm², the filling factor (FF) was measured as 69.23%, and the power conversion efficiency (PCE) was measured as 13.73%. The surface adhesion of the active layer in this example was 16.82 nN. The power conversion efficiency (PCE) of the cell after 5000 times of outward bending cycles was maintained as 88% of an initial value.

Relative to comparative example 1, the surface adhesion is improved by 179%, and the efficiency maintenance after bending cycle is improved by 5%.

### Example 9 (not included in the present invention)

An inverted organic solar cell structure in this example from bottom to top comprised a conductive substrate, an electron transport layer, a thermoplastic polyether ester elastomer (TPEE) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material was 1:1.2, and the concentration of a solution was 8 mg/ml based on PM6; the selected thermoplastic elastomer was TPEE, and its ratio was 50%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 3 nm in thickness; the performances of the organic solar cell were tested under standard test conditions (AM1.5, 100 mW/cm²), the open circuit voltage (*V_{oc}*) of the cell was measured as 0.82 V, the short circuit current density (*J_{sc}*) was measured as 23.92 mA/cm², the filling factor (FF) was measured as 68.79%, and the power conversion efficiency (PCE) was measured as 13.49%. The surface adhesion of the active layer in this example was 21.26 nN. The power conversion efficiency (PCE) of the cell after 5000 times of outward bending cycles was maintained as 89% of an initial value.

Relative to comparative example 1, the surface adhesion is improved by 227%, and the efficiency maintenance after bending cycle is improved by 6%.

### Example 10 (not included in the present invention)

An inverted organic solar cell structure in this example from bottom to top comprised a conductive substrate, an electron transport layer, a thermoplastic polyamide elastomer (TPAE) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material is Y6, a mass ratio of the donor material to the acceptor material was 1:1.2, and the concentration of a solution is 8 mg/ml based on PM6; the selected thermoplastic elastomer was TPAE, and its ratio was 30%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 2 nm in thickness; the performances of the organic solar cell were tested under standard test conditions (AM1.5, 100 mW/cm²), the open circuit voltage (*V_{oc}*) of the cell was measured as 0.82 V, the short circuit current density (*J_{sc}*) was measured as 24.68 mA/cm², the filling factor (FF) was measured as 69.91%, and the power conversion efficiency (PCE) was measured as 14.15%. The surface adhesion of the active layer in this example was 17.24 nN. The power conversion efficiency (PCE) of the cell after 5000 times of outward bending cycles was maintained as 85% of an initial value.

Relative to comparative example 1, the surface adhesion is improved by 184%, and the efficiency maintenance after bending cycle is improved by 2%.

### Example 11 (not included in the present invention)

An inverted organic solar cell structure in this example from bottom to top comprised a conductive substrate, an electron transport layer, a triphenyl phosphate (TPF) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material was 1:1.2, and the concentration of a solution is 8 mg/ml based on PM6; the selected thermoplastic elastomer was TPF, and its ratio is 50%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 6 nm in thickness; the performances of the organic solar cell were tested under standard test conditions (AM1.5, 100 mW/cm²), the open circuit voltage (*V_{oc}*) of the cell was measured as 0.82 V, the short circuit current density (*J_{sc}*) was measured as 23.53 mA/cm², the filling factor (FF) was measured as 68.72%, and the power conversion efficiency (PCE) was measured as 13.26%. The surface adhesion of the active layer in this example was 16.86 nN. The power conversion efficiency (PCE) of the cell after 5000 times of outward bending cycles was maintained as 89% of an initial value.

Relative to comparative example 1, the surface adhesion is improved by 180%, and the efficiency maintenance after bending cycle is improved by 6%.

### Example 12 (not included in the present invention)

An inverted organic solar cell structure in this example from bottom to top comprised a conductive substrate, an electron transport layer, a thermoplastic silicon vulcanizate (TPSIV) doped active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; in the active layer, a donor material was PM6, an acceptor material was Y6, a mass ratio of the donor material to the acceptor material as 1:1.2, and the concentration of a solution was 8 mg/ml based on PM6; the selected thermoplastic elastomer was TPSiV, and its ratio was 20%; the hole transport layer was vacuum evaporated molybdenum oxide with a thickness of 20 nm; the metal electrode was vacuum evaporated aluminum with a thickness of 150 nm. In this ratio, the thermoplastic elastomer enrichment layer formed on the surface of the active layer was 1 nm in thickness; the performances of the organic solar cell were tested under standard test conditions (AM1.5, 100 mW/cm²), the open circuit voltage (*V_{oc}*) of the cell was measured as 0.81 V, the short circuit current density (*J_{sc}*) was measured as 24.35 mA/cm², the filling factor (FF) was measured as 69.36%, and the power conversion efficiency (PCE) was measured as 13.68%. The surface adhesion of the active layer in this example was 19.12 nN. The power conversion efficiency (PCE) of the cell after 5000 times of outward bending cycles was maintained as 86% of an initial value.

Relative to comparative example 1, the surface adhesion is improved by 204%, and the efficiency maintenance after bending cycle is improved by 3%.

### Example 13 (not included in the present invention)

An inverted organic solar cell structure based on a thermoplastic elastomer as an elastomer interface layer in this example from bottom to top comprised a conductive substrate, an electron transport layer, an active layer, an elastomer interface layer (i.e., thermoplastic elastomer layer), a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared is cyclohexane, the selected thermoplastic elastomer was SEBS, and the thickness of the elastomer interface layer was 0.1 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.83 V, the short circuit current density was measured as 25.05 mA/cm², the filling factor (FF) was measured as 68.97%, and the power conversion efficiency (PCE) was measured as 14.21%. The surface adhesion of the active layer in this example was 12.48 nN. The power conversion efficiency (PCE) of the cell after 5000 times of outward bending cycles was maintained as 85% of an initial value.

Relative to comparative example 1, the surface adhesion is improved by 117%, and the efficiency maintenance after bending cycle is improved by 2%.

FIG. 7 is a normalized UV-visible absorption spectrogram of an SEBS upper interface layer based on active layer PM6:Y6 in this example.

### Example 14 (not included in the present invention)

An inverted organic solar cell structure based on a thermoplastic elastomer as an elastomer interface layer in this example from bottom to top comprised a conductive substrate, an electron transport layer, an active layer, an elastomer interface layer (i.e., thermoplastic elastomer layer), a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared was n-hexane, the selected thermoplastic elastomer was SEBS, and the thickness of the elastomer interface layer was 2 nm; in the active layer, a donor material is PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.82 V, the short circuit current density was measured as 24.82 mA/cm², the filling factor (FF) was measured as 69.39%, and the power conversion efficiency (PCE) was measured as 14.13%. The surface adhesion of the active layer in this example was 38.57 nN. The power conversion efficiency (PCE) of the cell after 5000 times of outward bending cycles was maintained as 95% of an initial value.

Relative to comparative example 1, the surface adhesion is improved by 410%, and the efficiency maintenance after bending cycle is improved by 12%.

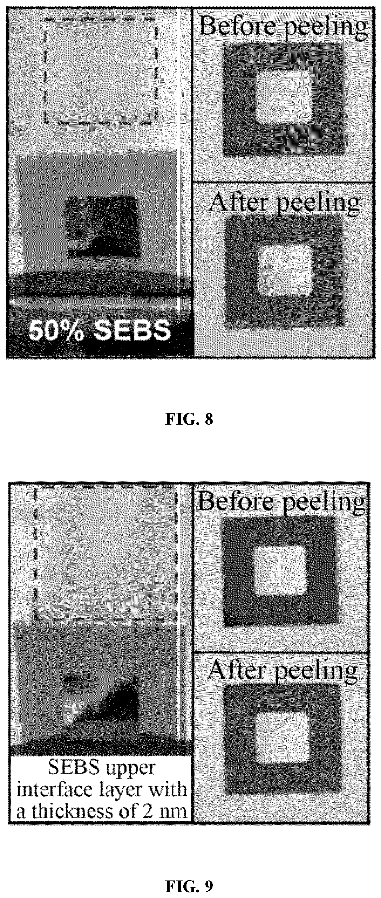

FIG. 8 shows that in this example, the adhesion of MoO₃ and Al on an active layer is improved when SEBS is an upper surface adhesive layer, use of 3M adhesive tap does not allow the film to fall off. By comparison, complete peeling occurs for a film without SEBS as the adhesive layer. FIG. 9 is a picture showing that detachment of MoO₃ and Al does not occur on SEBS as an upper interface adhesion layer of PM6:Y6 active layer.

### Example 15 (not included in the present invention)

An inverted organic solar cell structure based on a thermoplastic elastomer as an elastomer interface layer in this example from bottom to top comprised a conductive substrate, an electron transport layer, an active layer, an elastomer interface layer (i.e., thermoplastic elastomer layer), a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared is cyclohexane, the selected thermoplastic elastomer was SEBS, and the thickness of the elastomer interface layer was 20 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.82 V, the short circuit current density was measured as 23.46 mA/cm², the filling factor (FF) was measured as 49.62%, and the power conversion efficiency (PCE) was measured as 9.52%. The surface adhesion of the active layer in this example was 36.49 nN. The power conversion efficiency (PCE) of the cell after 5000 times of outward bending cycles was maintained as 94% of an initial value.

Relative to comparative example 1, the surface adhesion is improved by 389%, and the efficiency maintenance after bending cycle is improved by 11%.

### Example 16 (not included in the present invention)

An inverted organic solar cell structure based on a thermoplastic elastomer as an elastomer interface layer in this example from bottom to top comprised a conductive substrate, an electron transport layer, an elastomer interface layer (i.e., thermoplastic elastomer layer), an active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared is n-butane, the selected thermoplastic elastomer was SEBS, and the thickness of the elastomer interface layer was 4 nm; in the active layer, a donor material was PM6, an acceptor material wasY6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.82 V, the short circuit current density was measured as 24.38 mA/cm², the filling factor (FF) was measured as 69.15%, and the power conversion efficiency (PCE) was measured as 13.82%. The surface adhesion of the active layer in this example was 15.89 nN. The power conversion efficiency (PCE) of the cell after 5000 times of outward bending cycles was maintained as 91% of an initial value.

Relative to comparative example 1, the surface adhesion is improved by 169%, and the efficiency maintenance after bending cycle is improved by 8%.

### Example 17 (not included in the present invention)

An inverted organic solar cell structure based on a thermoplastic elastomer as an elastomer interface layer in this example from bottom to top comprised a conductive substrate, an electron transport layer, an elastomer interface layer (i.e., thermoplastic elastomer layer), an active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared is n-butane, the selected thermoplastic elastomer was TPU, and the thickness of the elastomer interface layer was 4 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.81 V, the short circuit current density was measured as 24.96 mA/cm², the filling factor (FF) was measured as 69.52%, and the power conversion efficiency (PCE) was measured as 14.05%. The surface adhesion of the active layer in this example was 18.26 nN. The power conversion efficiency (PCE) of the cell after 5000 times of outward bending cycles was maintained as 90% of an initial value.

Relative to comparative example 1, the surface adhesion is improved by 195%, and the efficiency maintenance after bending cycle is improved by 7%.

### Example 18 (not included in the present invention)

An inverted organic solar cell structure based on a thermoplastic elastomer as an elastomer interface layer in this example from bottom to top comprised a conductive substrate, an electron transport layer, an elastomer interface layer (i.e., thermoplastic elastomer layer), an active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared is n-butane, the selected thermoplastic elastomer was TPF, and the thickness of the elastomer interface layer was 4 nm; in the active layer, a donor material was PM6, an acceptor material is Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.82 V, the short circuit current density was measured as 24.77 mA/cm², the filling factor (FF) was measured as 69.10%, and the power conversion efficiency (PCE) was measured as 14.02%. The surface adhesion of the active layer in this example was 17.65 nN. The power conversion efficiency (PCE) of the cell after 5000 times of outward bending cycles was maintained as 91% of an initial value.

Relative to comparative example 1, the surface adhesion is improved by 188%, and the efficiency maintenance after bending cycle is improved by 8%.

### Example 19 (not included in the present invention)

An inverted organic solar cell structure based on a thermoplastic elastomer as an elastomer interface layer in this example from bottom to top comprised a conductive substrate, an electron transport layer, an elastomer interface layer (i.e., thermoplastic elastomer layer), an active layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared is n-butane, the selected thermoplastic elastomer was TPAE, and the thickness of the elastomer interface layer was 4 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.82 V, the short circuit current density was measured as 25.01 mA/cm², the filling factor (FF) was measured as 68.82%, and the power conversion efficiency (PCE) was measured as 14.11%. The surface adhesion of the active layer in this example was 15.67 nN. The power conversion efficiency (PCE) of the cell after 5000 times of outward bending cycles was maintained as 89% of an initial value.

Relative to comparative example 1, the surface adhesion is improved by 167%, and the efficiency maintenance after bending cycle is improved by 6%.

### Example 20

An inverted organic solar cell structure based on a thermoplastic elastomer as an elastomer interface layer in this example from bottom to top comprised a conductive substrate, an electron transport layer, an elastomer interface layer (i.e., thermoplastic elastomer layer), an active layer, an elastomer interface layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared was n-butane, the selected thermoplastic elastomer was TPAE, and the thickness of the elastomer interface layer was 4 nm; in the active layer, a donor material is PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.81V, the short circuit current density was measured as 24.32 mA/cm², the filling factor (FF) was measured as 68.52%, and the power conversion efficiency (PCE) was measured as 13.44%. The surface adhesion of the active layer in this example was 19.52 nN. The power conversion efficiency (PCE) of the cell after 5000 times of outward bending cycles was maintained as 85% of an initial value.

Relative to comparative example 1, the surface adhesion is improved by 208%, and the efficiency maintenance after bending cycle is improved by 2%.

### Example 21

An inverted organic solar cell structure based on a thermoplastic elastomer as an elastomer interface layer in this example from bottom to top comprised a conductive substrate, an electron transport layer, a lower elastomer interface layer (i.e., thermoplastic elastomer layer), an active layer, an upper elastomer interface layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared was n-butane, the selected upper and lower thermoplastic elastomers were SEBS and TPI, with a thickness of 10 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.82 V, the short circuit current density was measured as 24.73 mA/cm², the filling factor (FF) was measured as 67.59%, and the power conversion efficiency (PCE) was measured as 13.70%. The surface adhesion of the active layer in this example was 17.68 nN. The power conversion efficiency (PCE) of the cell after 5000 times of outward bending cycles was maintained as 91% of an initial value.

Relative to comparative example 1, the surface adhesion is improved by 188%, and the efficiency maintenance after bending cycle is improved by 8%.

### Example 22

An inverted organic solar cell structure based on a thermoplastic elastomer as an elastomer interface layer in this example from bottom to top comprised a conductive substrate, an electron transport layer, a lower elastomer interface layer (i.e., thermoplastic elastomer layer), an active layer, an upper elastomer interface layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared was n-butane, the selected upper and lower thermoplastic elastomers were TPU and TPI with the thicknesses of 5 nm and 10 nm, respectively; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.81 V, the short circuit current density was measured as 23.88 mA/cm², the filling factor (FF) was measured as 69.15%, and the power conversion efficiency (PCE) was measured as 13.82%. The surface adhesion of the active layer in this example was 21.96 nN. The power conversion efficiency (PCE) of the cell after 5000 times of outward bending cycles was maintained as 92% of an initial value.

Relative to comparative example 1, the surface adhesion is improved by 234%, and the efficiency maintenance after bending cycle is improved by 9%.

### Example 23 (not included in the present invention)

An inverted organic solar cell structure based on a thermoplastic elastomer as an elastomer interface layer in this example from bottom to top comprised a conductive substrate, an electron transport layer, a lower elastomer interface layer (i.e., thermoplastic elastomer layer), an active layer, an upper elastomer interface layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared was n-butane, the selected upper and lower thermoplastic elastomers were SEBS with thicknesses of 10 nm and 20 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.82 V, the short circuit current density was measured as 24.89 mA/cm², the filling factor (FF) was measured as 69.40%, and the power conversion efficiency (PCE) was measured as 14.16%. The surface adhesion of the active layer in this example was 33.95 nN. The power conversion efficiency (PCE) of the cell after 5000 times of outward bending cycles was maintained as 95% of an initial value.

Relative to comparative example 1, the surface adhesion is improved by 362%, and the efficiency maintenance after bending cycle is improved by 10%.

### Example 24 (not included in the present invention)

An inverted organic solar cell structure based on a thermoplastic elastomer as an elastomer interface layer in this example from bottom to top comprised a conductive substrate, a lower elastomer interface layer (i.e., thermoplastic elastomer layer), an electron transport layer, an active layer, an upper elastomer interface layer, a hole transport layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared was n-butane, the selected upper and lower thermoplastic elastomers were SEBS with thicknesses of 10 nm and 20 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.82 V, the short circuit current density was measured as 25.00 mA/cm², the filling factor (FF) was measured as 70.01%, and the power conversion efficiency (PCE) was measured as 14.37%. The surface adhesion of the active layer in this example was 40.00 nN. The power conversion efficiency (PCE) of the cell after 5000 times of outward bending cycles was maintained as 95% of an initial value.

Relative to comparative example 1, the surface adhesion is improved by 250%, and the efficiency maintenance after bending cycle is improved by 20%.

### Example 25 (not included in the present invention)

An inverted organic solar cell structure based on a thermoplastic elastomer as an elastomer interface layer in this example from bottom to top comprised a conductive substrate, a lower elastomer interface layer (i.e., thermoplastic elastomer layer), an electron transport layer, an active layer, a hole transport layer, an upper elastomer interface layer and a metal electrode, respectively. The conductive substrate was a polyethylene terephthalate film covered with silver nanowires on the surface; the electron transport layer was a zinc oxide nanoparticle film with a thickness of 10 nm; a solvent used when the thermoplastic elastomer layer was prepared was n-butane, the selected upper and lower thermoplastic elastomers were both SEBS with thicknesses of 15 nm and 30 nm; in the active layer, a donor material was PM6, an acceptor material was Y6, a mass ratio of the donor material to the acceptor material was 1:1.2, and the concentration of a solution was 8 mg/ml based on PM6; the hole transport layer was vacuum evaporated molybdenum oxide with a thickness of 10 nm; the metal electrode was vacuum evaporated aluminum with a thickness of 150 nm. The performances of the organic solar cell were tested under standard test conditions (AM1.5, 100 mW/cm²). The open circuit voltage of the cell was measured as 0.822 V, the short circuit current density was measured as 25.22 mA/cm², the filling factor (FF) was measured as 70.11%, and the power conversion efficiency (PCE) was measured as 14.53%. The surface adhesion of the active layer in this example was 41.20 nN. The power conversion efficiency (PCE) of the cell after 5000 times of outward bending cycles was maintained as 97% of an initial value.

Relative to comparative example 1, the surface adhesion is improved by 310%, and the efficiency maintenance after bending cycle is improved by 25%.

In addition, the inventor of this case conducted a test by using other raw materials, process operations and process conditions described in this specification with reference to the previous examples, and obtained ideal results.

Various aspects, embodiments, features and examples of the present application should be considered as being illustrative in all aspects and are not intended to limit the present application, and the scope of the present application are defined by claims. Those skilled in the art will understand other embodiments, modifications and uses without departing from the spirit and scope of the present application.

Although the present application has been described with reference to illustrative embodiments, various other changes, omissions and/or additions can also be made without departing from the spirit and scope of the present application and elements in examples can be replaced with essential equivalents. In addition, many modifications are made without departing from the scope of the present application so that specific situations or materials are adaptive to the teaching of the present application. Therefore, this article is not intended to limit the present application for use in implementing specific embodiments disclosed in the present application, but rather to include all embodiments within the scope of the attached claims.

## Claims

1. An organic solar cell in an inverted structure, comprising successively from bottom to top:
a conductive substrate, an electron transport layer, a first elastomer interface layer formed by thermoplastic elastomers, an active layer, a second elastomer interface layer formed by thermoplastic elastomers, a hole transport layer, and a metal electrode; wherein the first elastomer interface layer is directly between the electron transport layer and the active layer, and the second elastomer interface layer is directly between the active layer and the hole transport layer;
**characterized in that** each
elastomer interface layer has a thickness of 2-10 nm.

2. The organic solar cell according to claim 1, wherein the thermoplastic elastomer comprises a combination of any one or more than two of a styrenic thermoplastic elastomer, an olefin thermoplastic elastomer, a diene thermoplastic elastomer, a vinyl chloride thermoplastic elastomer, a polyurethane thermoplastic elastomer, an ester thermoplastic elastomer, an amide thermoplastic elastomer, an organic fluorine thermoplastic elastomer, an organic silicon thermoplastic elastomer and an ethylene thermoplastic elastomer;
and/or, the thickness of the active layer is 20-1000 nm, preferably 100-150 nm.

3. The organic solar cell according to claim 1, wherein an elastomer interface layer formed by thermoplastic elastomers is arranged between the hole transport layer and the metal electrode.

4. The organic solar cell according to claim 1, wherein the conductive substrate comprises a polyethylene terephthalate, polyethylene naphthalate or polyimide flexible film covered with any one of a metal nanowire, a metal oxide, a metal grid, graphene and a carbon nanotube on the surface, preferably, the conductive substrate is the polyethylene terephthalate flexible film covered with the silver nanowire on the surface;
and/or, the material of the electron transport layer comprises a combination of any one or more than two of a zinc oxide nanoparticle, a sol-gel zinc oxide, PFN-Br and PDINO, preferably, the electron transport layer is the zinc oxide nanoparticle, preferably, the thickness of the electron transport layer is 10-30 nm;
and/or, the material of the hole transport layer comprises molybdenum oxide and/or PEDOT:PSS, preferably molybdenum oxide, preferably, the thickness of the hole transport layer is 10-30 nm;
and/or, the material of the metal electrode comprises aluminum, silver or gold, preferably, the thickness of the metal electrode is 50-1000 nm.

5. A preparation method of the organic solar cell according to any one of claims 1-4, comprising, in an inverted sequence: providing a conductive substrate; forming an electron transport layer on the conductive substrate; forming the first elastomer interface layer directly on the electron transport layer by depositing a solution of thermoplastic elastomers; forming an active layer on the first elastomer interface layer; forming the second elastomer interface layer directly on the active layer by depositing a solution of thermoplastic elastomers; forming a hole transport layer on the second elastomer interface layer; and forming a metal electrode; **characterized in that** each elastomer interface layer has a thickness of 2-10 nm and is formed by a coating method selected from spin coating, scratch coating, slit coating, gravure printing or inkjet printing.

6. The preparation method according to claim 5, comprising: arranging the elastomer interface layer between the hole transport layer and the electrode.

7. The preparation method according to claim 5, comprising: preparing the hole transport layer by using any one of vacuum evaporation, spin coating, scraping coating, slit coating, gravure printing and inkjet printing;
and/or, the preparation method comprising: preparing the metal electrode by using any one of vacuum evaporation, spin coating, scraping coating, slit coating and inkjet printing.

8. The preparation method according to claim 5, further comprising:
forming the thermoplastic elastomer between the metal electrode and the hole transport layer to form the elastomer interface layer;
preferably, the method comprising:
mixing a donor material with an acceptor material to form active layer ink;
dissolving thermoplastic elastomers into a first solvent, and then blending the above mixture with the active layer ink to form the active layer;
especially preferably, a mass ratio of the thermoplastic elastomers to the donor material being less than 2:1, preferably 0.5-1.5: 1; and/or, the thickness of the active layer being 20-1000 nm, preferably 100-150nm;
especially preferably, the first solvent comprising a combination of any one or more than two of chloroform, chlorobenzene, tetrahydrofuran, dichlorobenzene, toluene, xylene and trimethylbenzene, preferably chloroform and/or chlorobenzene.

9. The preparation method according to claim 5, comprising: dissolving the thermoplastic elastomers into a selected solvent, wherein
the thermoplastic elastomer solution is deposited above the active layer, the selected solvent being a second solvent which comprises a combination of any one or more than two of an alcohol solvent, cycloalkane and alkane, preferably cycloalkane; and
preferably, when the thermoplastic elastomer solution is deposited under the active layer, the selected solvent being a third solvent which comprises a combination of any one or more than two of an alcohol solvent, cycloalkane, alkane, chloroform, chlorobenzene, tetrahydrofuran, dichlorobenzene, toluene, xylene and trimethylbenzene, preferably methanol.

## Patentansprüche

1. Organische Solarzelle in invertierter Struktur, umfassend aufeinanderfolgend von unten nach oben: ein leitfähiges Substrat, eine Elektronentransportschicht, eine erste Elastomer-Grenzflächenschicht, die aus thermoplastischen Elastomeren gebildet ist, eine aktive Schicht, eine zweite Elastomer-Grenzflächenschicht, die aus thermoplastischen Elastomeren gebildet ist, eine Lochtransportschicht und eine Metallelektrode; wobei die erste Elastomer-Grenzflächenschicht direkt zwischen der Elektronentransportschicht und der aktiven Schicht liegt und die zweite Elastomer-Grenzflächenschicht direkt zwischen der aktiven Schicht und der Lochtransportschicht liegt; **dadurch gekennzeichnet, dass** jede Elastomer-Grenzflächenschicht eine Dicke von 2 bis 10 nm aufweist.

2. Organische Solarzelle nach Anspruch 1, wobei das thermoplastische Elastomer eine Kombination aus beliebig einem oder mehr als zwei der folgenden umfasst: ein styrolisches thermoplastisches Elastomer, ein olefinisches thermoplastisches Elastomer, ein dienisches thermoplastisches Elastomer, ein vinylchloridbasiertes thermoplastisches Elastomer, ein Polyurethan-thermoplastisches Elastomer, ein Ester-thermoplastisches Elastomer, ein Amid-thermoplastisches Elastomer, ein organisches Fluor-thermoplastisches Elastomer, ein organisches Silicium-thermoplastisches Elastomer und ein Ethylen-thermoplastisches Elastomer;
und/oder die Dicke der aktiven Schicht 20-1000 nm beträgt, vorzugsweise 100-150 nm.

3. Organische Solarzelle nach Anspruch 1, wobei eine Elastomer-Grenzflächenschicht, die aus thermoplastischen Elastomeren gebildet ist, zwischen der Lochtransportschicht und der Metallelektrode angeordnet ist.

4. Organische Solarzelle nach Anspruch 1, wobei das leitfähige Substrat eine flexible Folie aus Polyethylenterephthalat, Polyethylennaphthalat oder Polyimid umfasst, die auf der Oberfläche mit beliebig einem von einem Metallnanodraht, einem Metalloxid, einem Metallgitter, Graphen und Kohlenstoffnanoröhren bedeckt ist, wobei vorzugsweise das leitfähige Substrat die flexible Folie aus Polyethylenterephthalat ist, die auf der Oberfläche mit Silbernanodrähten bedeckt ist;
und/oder das Material der Elektronentransportschicht eine Kombination aus beliebig einem oder mehr als zwei von einem Zinkoxid-Nanopartikel, einem Sol-Gel-Zinkoxid, PFN-Br und PDINO umfasst, wobei vorzugsweise die Elektronentransportschicht ein Zinkoxid-Nanopartikel ist, wobei vorzugsweise die Dicke der Elektronentransportschicht 10 bis 30 nm beträgt;
und/oder das Material der Lochtransportschicht Molybdänoxid und/oder PEDOT:PSS umfasst, vorzugsweise Molybdänoxid, wobei vorzugsweise die Dicke der Lochtransportschicht 10 bis 30 nm beträgt;
und/oder das Material der Metallelektrode Aluminium, Silber oder Gold umfasst, wobei vorzugsweise die Dicke der Metallelektrode 50 bis 1000 nm beträgt.

5. Herstellungsverfahren der organischen Solarzelle nach einem der Ansprüche 1 bis 4, umfassend, in einer invertierten Reihenfolge: Bereitstellen eines leitfähigen Substrats; Bilden einer Elektronentransportschicht auf dem leitfähigen Substrat; Bilden der ersten Elastomer-Grenzflächenschicht direkt auf der Elektronentransportschicht durch Abscheiden einer Lösung aus thermoplastischen Elastomeren; Bilden einer aktiven Schicht auf der ersten Elastomer-Grenzflächenschicht; Bilden der zweiten Elastomer-Grenzflächenschicht direkt auf der aktiven Schicht durch Abscheiden einer Lösung aus thermoplastischen Elastomeren; Bilden einer Lochtransportschicht auf der zweiten Elastomer-Grenzflächenschicht; und Bilden einer Metallelektrode; **dadurch gekennzeichnet, dass** jede Elastomer-Grenzflächenschicht eine Dicke von 2 bis 10 nm aufweist und durch ein Beschichtungsverfahren gebildet wird, ausgewählt aus Spin-Coating, Rakelbeschichten, Schlitzdüsenbeschichten, Tiefdruck oder Tintenstrahldruck.

6. Herstellungsverfahren nach Anspruch 5, umfassend: Anordnen der Elastomer-Grenzflächenschicht zwischen der Lochtransportschicht und der Elektrode.

7. Herstellungsverfahren nach Anspruch 5, umfassend: Herstellen der Lochtransportschicht unter Verwendung von beliebig einem von Vakuumverdampfung, Spin-Coating, Rakelbeschichten, Schlitzdüsenbeschichten, Tiefdruck und Tintenstrahldruck;
und/oder das Herstellungsverfahren umfassend: Herstellen der Metallelektrode unter Verwendung von beliebig einem von Vakuumverdampfung, Spin-Coating, Rakelbeschichten, Schlitzdüsenbeschichten und Tintenstrahldruck.

8. Herstellungsverfahren nach Anspruch 5, ferner umfassend:
Bilden einer Schicht aus thermoplastischen Elastomeren zwischen der Metallelektrode und der Lochtransportschicht, um die Elastomer-Grenzflächenschicht zu bilden;
vorzugsweise wobei das Verfahren umfasst:
Mischen eines Donormaterials mit einem Akzeptormaterial, um eine Aktivschichttinte zu bilden;
Lösen thermoplastischer Elastomere in einem ersten Lösungsmittel und anschließendes Mischen der obigen Mischung mit der Aktivschichttinte, um die aktive Schicht zu bilden;
besonders vorzugsweise wobei ein Massenverhältnis der thermoplastischen Elastomere zu dem Donormaterial von weniger als 2:1, vorzugsweise 0,5 bis 1,5:1, beträgt; und/oder die Dicke der aktiven Schicht 20 bis 1000 nm, vorzugsweise 100 bis 150 nm, beträgt;
besonders vorzugsweise wobei das erste Lösungsmittel eine Kombination aus beliebig einem oder mehr als zwei von Chloroform, Chlorbenzol, Tetrahydrofuran, Dichlorbenzol, Toluol, Xylol und Trimethylbenzol umfasst, vorzugsweise Chloroform und/oder Chlorbenzol.

9. Herstellungsverfahren nach Anspruch 5, umfassend: Lösen der thermoplastischen Elastomere in einem ausgewählten Lösungsmittel, wobei die thermoplastische Elastomerlösung oberhalb der aktiven Schicht abgeschieden wird, wobei das ausgewählte Lösungsmittel ein zweites Lösungsmittel ist, das eine Kombination aus beliebig einem oder mehr als zwei von einem Alkohollösungsmittel, Cycloalkan und Alkan umfasst, vorzugsweise Cycloalkan; und
vorzugsweise wobei, wenn die thermoplastische Elastomerlösung unter der aktiven Schicht abgeschieden wird, das ausgewählte Lösungsmittel ein drittes Lösungsmittel ist, das eine Kombination aus beliebig einem oder mehr als zwei von einem Alkohollösungsmittel, Cycloalkan, Alkan, Chloroform, Chlorbenzol, Tetrahydrofuran, Dichlorbenzol, Toluol, Xylol und Trimethylbenzol umfasst, vorzugsweise Methanol.

## Revendications

1. Cellule solaire organique selon une structure inversée, comprenant, successivement du bas vers le haut : un substrat conducteur, une couche de transport d'électrons, une première couche d'interface élastomère formée par des élastomères thermoplastiques, une couche active, une deuxième couche d'interface élastomère formée par des élastomères thermoplastiques, une couche de transport de trous, et une électrode métallique ; dans laquelle la première couche d'interface élastomère se trouve directement entre la couche de transport d'électrons et la couche active, et la deuxième couche d'interface élastomère se trouve directement entre la couche active et la couche de transport de trous ; **caractérisée en ce que** chaque couche d'interface élastomère présente une épaisseur de 2-10 nm.

2. Cellule solaire organique selon la revendication 1, dans laquelle l'élastomère thermoplastique comprend une combinaison de l'un quelconque ou plus de deux parmi un élastomère thermoplastique styrénique, un élastomère thermoplastique oléfinique, un élastomère thermoplastique diénique, un élastomère thermoplastique de chlorure de vinyle, un élastomère thermoplastique de polyuréthane, un élastomère thermoplastique d'ester, un élastomère thermoplastique d'amide, un élastomère thermoplastique de fluor organique, un élastomère thermoplastique de silicium organique et un élastomère thermoplastique d'éthylène ;
et/ou, l'épaisseur de la couche active est de 20-1000 nm, de préférence de 100-150 nm.

3. Cellule solaire organique selon la revendication 1, dans laquelle une couche d'interface élastomère formée par des élastomères thermoplastiques est disposée entre la couche de transport de trous et l'électrode métallique.

4. Cellule solaire organique selon la revendication 1, dans laquelle le substrat conducteur comprend un film souple de polytéréphtalate d'éthylène, de polynaphtalate d'éthylène ou de polyimide recouvert de l'un quelconque parmi un nanofil métallique, un oxyde métallique, une grille métallique, du graphène et un nanotube de carbone sur la surface, de préférence, le substrat conducteur est le film souple de polytéréphtalate d'éthylène recouvert du nanofil d'argent sur la surface ;
et/ou, le matériau de la couche de transport d'électrons comprend une combinaison de l'une quelconque ou plus de deux parmi une nanoparticule d'oxyde de zinc, un oxyde de zinc sol-gel, du PFN-Br et du PDINO, de préférence, la couche de transport d'électrons est la nanoparticule d'oxyde de zinc, de préférence, l'épaisseur de la couche de transport d'électrons est de 10-30 nm ;
et/ou, le matériau de la couche de transport de trous comprend de l'oxyde de molybdène et/ou du PEDOT:PSS, de préférence de l'oxyde de molybdène, de préférence, l'épaisseur de la couche de transport de trous est de 10-30 nm ;
et/ou, le matériau de l'électrode métallique comprend de l'aluminium, de l'argent ou de l'or, de préférence, l'épaisseur de l'électrode métallique est de 50-1000 nm.

5. Procédé de préparation de la cellule solaire organique selon l'une quelconque des revendications 1-4, comprenant, selon une séquence inversée : la fourniture d'un substrat conducteur ; la formation d'une couche de transport d'électrons sur le substrat conducteur ; la formation de la première couche d'interface élastomère directement sur la couche de transport d'électrons par dépôt d'une solution d'élastomères thermoplastiques ; la formation d'une couche active sur la première couche d'interface élastomère ; la formation de la deuxième couche d'interface élastomère directement sur la couche active par dépôt d'une solution d'élastomères thermoplastiques ; la formation d'une couche de transport de trous sur la deuxième couche d'interface d'élastomère ; et la formation d'une électrode métallique ; **caractérisé en ce que** chaque couche d'interface élastomère présente une épaisseur de 2-10 nm et est formée par un procédé de revêtement sélectionné parmi une enduction centrifuge, un revêtement en fente, une héliogravure et une impression par jet d'encre.

6. Procédé de préparation selon la revendication 5, comprenant : la disposition de la couche d'interface élastomère entre la couche de transport de trous et l'électrode.

7. Procédé de préparation selon la revendication 5, comprenant : la préparation de la couche de transport de trous en utilisant l'un quelconque parmi une évaporation sous vide, une enduction centrifuge, un revêtement par raclage, un revêtement en fente, une héliogravure et une impression par jet d'encre ;
et/ou, le procédé de préparation comprenant : la préparation de l'électrode métallique en utilisant l'un quelconque parmi une évaporation sous vide, une enduction centrifuge, un revêtement de raclage, un revêtement en fente et une impression par jet d'encre.

8. Procédé de préparation selon la revendication 5, comprenant en outre :
la formation de l'élastomère thermoplastique entre l'électrode métallique et la couche de transport de trous pour former la couche d'interface élastomère ;
de préférence, le procédé comprenant :
le mélange d'un matériau donneur avec un matériau accepteur pour former une encre de couche active ;
la dissolution d'élastomères thermoplastiques dans un premier solvant, puis le mélange du mélange ci-dessus avec l'encre de couche active pour former la couche active ;
de manière particulièrement préférable, un rapport massique des élastomères thermoplastiques au matériau donneur étant inférieur à 2:1, de préférence de 0,5-1,5:1 ; et/ou, l'épaisseur de la couche active étant de 20-1000 nm, de préférence de 100-150 nm ;
de manière particulièrement préférable, le premier solvant comprenant une combinaison de l'un quelconque ou plus de deux parmi le chloroforme, le chlorobenzène, le tétrahydrofurane, le dichlorobenzène, le toluène, le xylène et le triméthylbenzène, de préférence le chloroforme et/ou le chlorobenzène.

9. Procédé de préparation selon la revendication 5, comprenant : la dissolution des élastomères thermoplastiques dans un solvant sélectionné, dans lequel la solution d'élastomère thermoplastique est déposée au-dessus de la couche active, le solvant sélectionné étant un deuxième solvant qui comprend une combinaison de l'un quelconque ou plus de deux parmi un solvant alcoolique, un cycloalcane et un alcane, de préférence un cycloalcane ; et
de préférence, lorsque la solution d'élastomère thermoplastique est déposée sous la couche active, le solvant sélectionné étant un troisième solvant qui comprend une combinaison de l'un quelconque ou plus de deux parmi un solvant alcoolique, un cycloalcane, un alcane, le chloroforme, le chlorobenzène, le tétrahydrofurane, le dichlorobenzène, le toluène, le xylène et le triméthylbenzène, de préférence le méthanol.
